# EUROPEAN PATENT APPLICATION

(11) **EP 2 302 788 A1**
(43) Date of publication of application: **30.03.2011**
(21) Application number: 09171646.4
(22) Date of filing: 29.09.2009
(51) Int. Cl.: H03F 1/02, H03F 1/34, H03F 3/24, H04B 1/04, H04L 27/20

(54) **Load management for improved envelope tracking performance**

(71) Applicant: Alcatel-Lucent Deutschland AG, 70435 Stuttgart (DE)
(72) Inventor: Machinal, Robin, 70173 Stuttgart (DE); Wiegner, Dirk, 71409 Schwaikheim (DE)
(74) Representative: Kohler Schmid Möbus

(57) **Abstract**

The invention relates to a transmit frontend (1) for a base station (2), comprising: a power transistor (7a) for amplification of an RF signal (RF out), a modulator (9) for providing a modulated supply voltage (V_{MOD}) to the power transistor (7a), the modulated supply voltage (V_{MOD}) depending on an envelope of the RF signal (RF out), an adjustable DC power supply (10) for providing a supply voltage (Vₘₐₓ) to the modulator (9), the supply voltage (Vₘₐₓ) influencing a dynamic range of the modulator (9), and a load manager (5) for determining a traffic load condition of the base station (2) and for controlling the supply voltage (Vₘₐₓ) provided by the adjustable DC power supply (10) based on the determined traffic load condition. The invention also relates to a base station (2) and to a communications network (3) comprising such a transmit frontend (1), as well as to a corresponding method.

## Description

### Field of the Invention

The invention relates to the field of telecommunications, more specifically to power amplification of RF signals in base stations, in particular using the Envelope Tracking concept.

### Background

This section introduces aspects that may be helpful in facilitating a better understanding of the invention. Accordingly, the statements of this section are to be read in this light and are not to be understood as admissions about what is in the prior art or what is not in the prior art.

In order to improve efficiency of (single-band as well as multiband, single-standard as well as multistandard) power amplifiers and thus base stations, the Envelope Tracking concept is a very promising approach. The Envelope Tracking concept combines a RF power amplifier with an envelope modulator, providing a modulated supply voltage to a supply input terminal of the RF power amplifier, for example to the Drain feed of a field effect transistor element.

However, the envelope tracking concept as described above shows a certain load-dependent efficiency degradation. This is e.g. due to the fact that the output power (transmit power level) of the RF power amplifier generally changes depending on a traffic load condition of the base station. Typically, the transmit power is increased when a high traffic load is present in the base station, i.e. when a high number of users has to be served, the transmit power being decreased with decreasing traffic load in the base station, e.g. during nighttime.

### Summary of the Invention

The present invention is directed to addressing the effects of one or more of the problems set forth above. The following presents a simplified summary of the invention in order to provide a basic understanding of some aspects of the invention. This summary is not an exhaustive overview of the invention. It is not intended to identify key or critical elements of the invention or to delineate the scope of the invention. Its sole purpose is to present some concepts in a simplified form as a prelude to the more detailed description that is discussed later.

A first aspect of the invention relates to a transmit frontend for a base station, comprising: a power transistor for amplification of an RF signal, a modulator for providing a modulated supply voltage to the power transistor, the modulated supply voltage depending on an envelope of the RF signal, an adjustable DC power supply for providing a supply voltage to the modulator, the supply voltage influencing a dynamic range of the modulator, and a load manager for determining a traffic load condition of the base station and for controlling the supply voltage provided by the adjustable DC power supply based on the determined traffic load condition.

The inventors have found that the load-dependent efficiency degradation of the Envelope Tracking amplifier system and transmit frontend, respectively, is among others due to the fact that the envelope tracking modulator is usually supplied with a load-independent fixed maximum supply voltage. In other words, the modulator is supplied with a (high) maximum supply voltage also for low load situations for which the maximum voltage is not required.

It is thus proposed to use an adjustable DC power supply to provide load-dependent DC supply voltages to the envelope tracking modulator, thus allowing to set the maximum supply voltage to a desired value, and adjusting the upper limit of the dynamic range of the modulated supply voltage which is provided to the ET modulator accordingly. Adjusting the supply voltage provided to the modulator and thus the upper limit of the supply voltage range of the power transistor enables optimum and efficient supply voltage provision, thus leading to improved efficiency of the overall envelope tracking RF amplifier system.

The load manager may be adapted to determine the traffic load condition in the base station e.g. by signal analysis in the digital frontend of the base station. One skilled in the art will readily appreciate that there are different ways of measuring the load condition of the base station and will select an appropriate one according to circumstance.

In one embodiment, the adjustable DC power supply comprises a DC-to-DC converter for generating a plurality of discrete (fixed) voltage levels to be provided as a supply voltage to the modulator. In this case, the load manager tracks the traffic situation of the base station and selects an appropriate one of the discrete voltage levels, in accordance with the dynamic range of the RF transmit power currently used in the base station, being set by the load manager in dependence of the load condition.

One skilled in the art will readily appreciate that the switching between the different discrete supply voltages for the modulator is performed very slowly as compared to the modulation of the supply voltage being performed in the envelope modulator. Therefore, in one improvement, the DC power supply is (only) adapted to switch between the discrete voltage levels at a switching frequency being smaller than 100 kHz, preferably being smaller than 60 kHz, as higher switching frequencies may be undesired in some cases.

In a further embodiment, for performing synchronized control, the load manager and the DC power supply are adapted to communicate with each other. For providing an optimum fixed supply voltage to the envelope modulator in dependence of the traffic load, it is proposed to use a bi-directional communication between the load manager and the DC power supply for synchronization purposes, thus supporting optimum overall control and monitoring. It will be understood that such a bi-directional communication may be established between the load manager and the envelope modulator as well. In another embodiment, the load manager is implemented in a digital signal processing unit of a baseband part of the transmit frontend. In this case, the envelope modulator is a digitally controlled device, the load manager coordinating the control of the DC power supply and the envelope modulator. The arrangement of the load manager in the baseband part is advantageous, as information about the load condition, e.g. about signals received from wireless terminals, typically mobile stations, or about a power usage of a processor being e.g. arranged in the digital signal processing unit is available in the baseband part.

In one improvement, the transmit frontend further comprises a feedback path leading from an output of the power amplifier to the digital signal processing unit of the baseband part, the digital signal processing unit being adapted for performing digital pre-distortion of the RF signal based on the feedback for linearization of the amplification in the power amplifier. The feedback path which is used for providing the amplified RF signal back to the baseband part of the base station may be branched off from the RF signal path in a directional coupler provided after the power amplifier or antenna filter.

In a further improvement, the digital signal processing unit is adapted for providing an envelope of the RF signal to the envelope modulator. In this case, the envelope tracking modulator is adapted for processing a digital envelope signal at its input (with a number of N bits). Thus, it is not necessary to derive the envelope signal e.g. by use of a coupler from the (analogue) RF signal which is provided to the power amplifier, as the calculations required for generating the digital envelope signal can be performed in the digital signal processing unit of the baseband part. In this case, a digital baseband signal may be generated in the baseband part as well, the latter being converted to an analogue signal in a D/A conversion unit and be provided to a mixer for up-conversion of the baseband signal, thus generating an analogue RF signal to be amplified by the RF power amplifier.

In one embodiment, the modulator is a Switch Mode Assisted Linear Amplifier, SMALA. Switch mode assisted linear amplifiers are known in the art and typically comprise a linear amplifier stage and a switching amplifier stage, both being connected to a modulator output where the supply voltage to the power amplifier is provided. The linear amplifier stage amplifies an input signal corresponding to the envelope of the RF input signal to be amplified in the RF power amplifier. When the input signal level is high enough, the linear amplifier stage is supported by the switching amplifier stage which provides a fixed contribution (power provision) to the supply current. Thus, the non-linear switching amplifier stage helps to increase the efficiency of the SMALA, while the linear amplifier stage keeps the SMALA's characteristic linear. Such a SMALA may in particular be implemented as a digitally controlled device, a digital envelope signal being provided as an input signal to the SMALA in this case.

Further aspects of the invention relate to a base station comprising a transmit frontend as described above, and to a communication network comprising at least one such base station. The communication network and base station equipped with such a transmit frontend show improved envelope tracking amplifier performance (in particular with regard to efficiency) by shifting and/or scaling the dynamic range of the (typically digitally processed) envelope signal to a traffic-load related modulated supply voltage for the power amplifier.

A further aspect of the invention relates to a method for performing amplification of an RF signal in a power transistor of a base station of a wireless communication system, the method comprising: providing a modulated supply voltage from a modulator to the power transistor, the modulated supply voltage being dependent on an envelope of the RF signal, and providing a supply voltage to the modulator, the supply voltage influencing a dynamic range of the modulated supply voltage provided by the modulator, wherein the supply voltage of the modulator is selected in dependence of a traffic load condition of the base station. Instead of using one fixed supply voltage for the modulator, the supply voltage provided to the modulator may change depending on the load condition, thus modifying the maximum supply voltage / dynamic range of the modulated supply voltage for the RF power amplifier.

In one variant, the supply voltage is selected from a plurality of different discrete (fixed) voltage levels. Different DC voltage levels may be provided, e.g. by a DC/DC converter of the adjustable DC power supply.

In a further variant, the maximum supply voltage is switched, depending on the traffic load condition, at a switching frequency below 100 kHz, preferably below 60 kHz. As discussed above, the switching frequency of the supply voltage is relatively small as compared to the modulation frequency of the modulated supply voltage which is provided to the power transistor / amplifier.

A person of skill in the art will readily recognize that various steps of the above-described method(s) can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as magnetic discs and magnetic tapes, hard drives, or optically readable digital data storage media. The embodiments are also intended to cover computers, in particular field programmable gate arrays (FPGA), application-specific integrated circuits (ASIC), or digital signal processors (DSP) programmed to perform the steps of the above-described method(s). Other hardware, conventional and/or custom, may also be included.

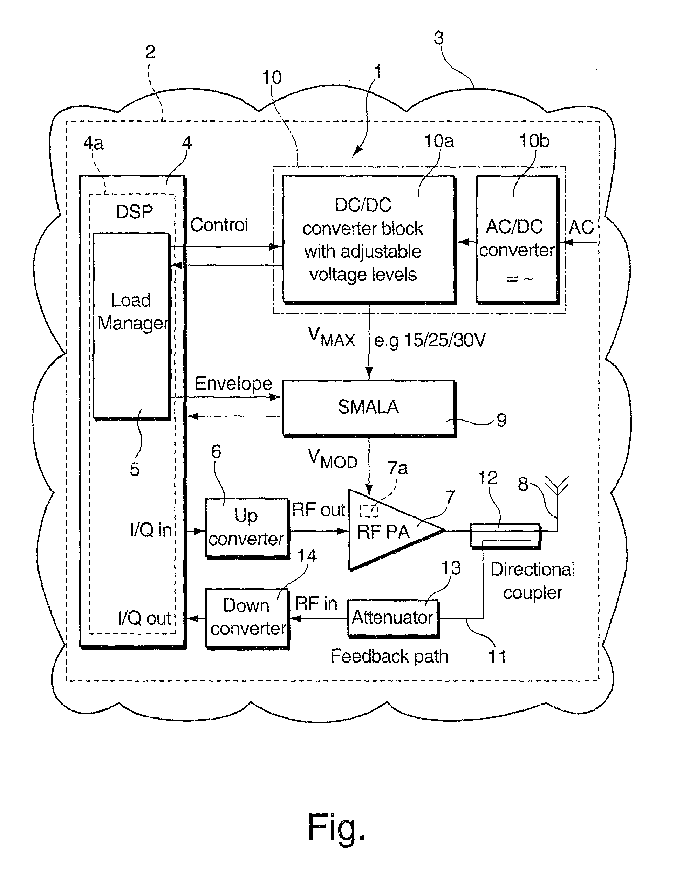

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Drawings

Exemplary embodiments are shown in the diagrammatic drawing and are explained in the description below. The following are shown:
- **Fig.**: shows a schematic diagram of an embodiment of a transmit frontend according to the invention.

### Detailed Description of Preferred Embodiments

The only **Figure** shows a transmit frontend **1** of a base station **2** which is part of a communications network **3.** The transmit frontend 1 comprises a baseband part 4 having a digital signal processor **4a** comprising a load manager **5** for determining a traffic load condition of the base station 2 and also for performing a modulator supply control related to the particular load situation in order to improve system efficiency for low load situations. The baseband part 4 is further adapted to generate a digital baseband signal comprising e.g. an in-phase and quadrature phase part, which is - typically after digital-to-analog conversion (not shown) - provided to an up-conversion unit **6** (mixer) for up-conversion of the baseband signal (typically in the MHz range) to a RF signal at a carrier frequency which is typically in the GHz range. The analog up-converted signal "RF out" is the fed to a RF power amplifier **7.** The RF power amplifier 7 comprises a power transistor **7a** for amplification of the RF signal "RF out", producing an amplified RF signal at its output which is lead to a transmit antenna **8** for radio transmission via an antenna network (not shown).

For improving efficiency of the amplification, a modulated supply voltage **V_{MOD}** is provided to an output terminal of the RF power transistor 7a. The RF power transistor 7a may be implemented as a field effect transistor or as a bipolar transistor. In the first case, transistor elements based on metal oxide semiconductor (MOS) technology or High Electron Mobility transistors (HEMT) using, for instance, gallium nitride (GaN) as a semiconductor material may be used. Alternatively, the power transistor may e.g. be implemented as a high-voltage hetero-junction bipolar transistor (HVHBT) using e.g. gallium arsenide (GaAs) as a semiconductor material. When a field effect transistor 7a is used, the drain terminal thereof forms the supply input terminal to which the modulated supply voltage V_{MOD} is provided.

The modulated supply voltage V_{MOD} is generated in an envelope modulator **9,** being implemented in the present case as a SMALA. The modulator 9 generates the modulated supply voltage V_{MOD} in dependence of an analogue signal "envelope" of the RF signal "RF out" to be amplified, the signal "envelope" being provided from the baseband part 4 to an input of the envelope modulator 9. Alternatively, the signal "envelope" may be provided to the envelope modulator 9 in digital form.

The dynamic range of the modulated supply voltage V_{MOD} is among others limited by a supply voltage **V_{MAX}** which is provided to the modulator 9 by a DC power supply **10.** The DC power supply **10** comprises a DC/DC converter block **10a** with adjustable output voltage levels and an AC/DC converter **10b** for converting an AC voltage to a DC voltage in the power supply 10, the AC voltage being provided by an external power source (not shown). The DC/DC converter block 10a is adapted to provide an output voltage signal V_{MAX} at one of e.g. three different voltage levels (for instance at 15 V, 25 V, and 30 V), thus allowing the modulator 9 to provide the modulated supply voltage V_{MOD} with three different dynamic ranges, being limited among others by the respective supply voltage V_{MAX} of 15 V, 25 V, and 30 V, respectively.

The DC/DC converter block 10a of the DC power supply 10 is controlled by the load manager 5 for selecting an appropriate one of the possible output voltage levels based on a traffic load condition of the base station 2. As the output (RF transmit) power of the RF power amplifier 7 is dependent on the traffic load condition, the supply voltage V_{MAX} may be adjusted in accordance with the traffic load, e.g. increasing the supply voltage V_{MAX} provided to the modulator 9 when the traffic load of the base station 2 is high, as a high transmit power is used in this case (in order to serve also mobile stations located at large distances from the base station 2), and reducing the supply voltage V_{MAX} when a low load situation predominates requiring lower transmit power provided by the base station 2. The traffic load of the base station 2 may be determined in the load manager 5, e.g., by measuring/monitoring the load traffic information of the base station 2, or by other suitable means.

In the transmit frontend 1 shown in the Figure, a feedback path **11** is provided, leading from a directional coupler **12** arranged at the output of the RF amplifier 7 to the digital signal processor 4a of the baseband part 4. In the feedback path 11, an attenuator **13** and a down-conversion unit **14** as well as e.g. additional filtering and analog to digital conversion (not shown) are provided. The digital baseband signal at the output of the down-conversion unit 14 is provided as a feedback signal to the digital signal processing unit 4a. The latter is adapted e.g. for performing digital pre-distortion of the RF signal "RF out" based on the feedback signal. The digital pre-distortion is used for linearization of the amplification in the power amplifier 7.

In the present example, the load manager 5 and the DC-to-DC converter block 10a perform bi-directional communications for synchronization purposes, thus allowing optimized control and monitoring. For the same purpose, the load manager 5 and the modulator 9 are adapted for performing bi-directional communications with each other.

Typically, the load manager 5 switches the supply voltage V_{MAX} between the discrete voltage levels at a switching frequency being considerably smaller than the one which is used for modulating the supply voltage V_{MOD} being provided to the RF power transistor 7a, the latter typically corresponding to the frequency with which the envelope signal "Envelope" changes. For instance, the load manager 5 may switch between the three discrete voltage levels at a switching frequency smaller than 100 kHz, or smaller than 60 kHz. It will be understood, however, that a power supply which is adapted to provide more or less than three (fixed) voltage levels may be used, it being also possible to use a power supply which allows to modify the values of the discrete (adjustable) voltage levels. Moreover, a power supply which allows for a continuous change of the value of the voltage level of the supply voltage V_{MAX} may be provided.

In summary, in the way described above, overall envelope tracking amplifier performance (in particular with regard to efficiency) may be improved by shifting and scaling the dynamic range of the digitally processed envelope signal to a traffic load-related modulated supply voltage.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Transmit frontend (1) for a base station (2), comprising:
a power transistor (7a) for amplification of an RF signal (RF out),
a modulator (9) for providing a modulated supply voltage (V_{MOD}) to the power transistor (7a), the modulated supply voltage (V_{MOD}) depending on an envelope of the RF signal (RF out),
an adjustable DC power supply (10) for providing a supply voltage (Vₘₐₓ) to the modulator (9), the supply voltage (Vₘₐₓ) influencing a dynamic range of the modulator (9), and
a load manager (5) for determining a traffic load condition of the base station (2) and for controlling the supply voltage (Vₘₐₓ) provided by the adjustable DC power supply (10) based on the determined traffic load condition.

2. Transmit frontend according to claim 1, wherein the DC power supply (10) comprises a DC-to-DC converter (10a) for generating a plurality of discrete voltage levels to be provided as a supply voltage (Vₘₐₓ) to the modulator (9).

3. Transmit frontend according to claim 2, wherein the DC power supply (10) is adapted to switch between the discrete voltage levels at a switching frequency smaller than 100 kHz, preferably smaller than 60 kHz.

4. Transmit frontend according to claim 1 or 2, wherein, for performing synchronized control, the load manager (5) and the DC power supply (10) are adapted to communicate with each other.

5. Transmit frontend according to any one of the preceding claims, wherein the load manager (5) is implemented in a digital signal processing unit (4a) of a baseband part (4) of the transmit frontend (1).

6. Transmit frontend according to claim 5, further comprising a feedback path (11) from an output of the power amplifier (7) to the digital signal processing unit (4a), the digital signal processing unit (4a) being adapted for performing digital pre-distortion of the RF signal (RF out) based on the feedback for linearization of the amplification in the power amplifier (7).

7. Transmit frontend according to claim 5 or 6, wherein the digital signal processing unit (4a) is adapted for providing an envelope of the RF signal (RF out) to the modulator (9).

8. Transmit frontend according to any one of the preceding claims, wherein the modulator (9) is a Switch Mode Assisted Linear Amplifier, SMALA.

9. Base station (2) comprising at least one transmit frontend (1) according to any one of the preceding claims.

10. Communication network (3) comprising at least one base station (2) according to claim 9.

11. Method for performing amplification of an RF signal (RF out) in a power transistor (7a) of a base station (2) of a wireless communication system (1), the method comprising:
providing a modulated supply voltage (V_{MOD}) from a modulator (9) to the power transistor (7a), the modulated supply voltage (V_{MOD}) being dependent on an envelope of the RF signal (RF out), and
providing a supply voltage (Vₘₐₓ) to the modulator (9), the supply voltage (Vₘₐₓ) influencing a dynamic range of the modulator (9), wherein
the supply voltage (Vₘₐₓ) provided to the modulator (9) is selected in dependence of a traffic load condition of the base station (2).

12. Method according to claim 11, wherein the supply voltage (Vₘₐₓ) is selected from a plurality of different discrete voltage levels.

13. Method according to claim 12, wherein the maximum supply voltage (Vₘₐₓ) provided to the modulator (9) is switched, depending on the traffic load condition, at a switching frequency below 100 kHz, preferably below 60 kHz.
